# FASCICULE DE BREVET EUROPEEN

(11) **EP 1 114 456 B1**
(45) Date de publication et mention de la délivrance du brevet: **12.05.2010**
(21) Numéro de dépôt: 99939495.0
(22) Date de dépôt: 24.08.1999
(51) Int. Cl.: H01L 23/14, H01L 21/784, H01L 23/051, H01L 21/60

(54) **PROCEDE COLLECTIF DE CONDITIONNEMENT D'UNE PLURALITE DE COMPOSANTS FORMES INITIALEMENT DANS UN MEME SUBSTRAT**
GEMEINSAMES VERFAHREN ZUM HERSTELLEN EINER MEHRZAHL VON BAUELEMENTEN WELCHE URSPRÜNGLICH IN DASSELBE SUBSTRAT GEFORMT SIND
COLLECTIVE METHOD FOR CONDITIONING A PLURALITY OF COMPONENTS INITIALLY FORMED IN A COMMON SUBSTRATE

(30) Priorité: 25.08.1998 FR 9810685
(43) Date de publication de la demande: 11.07.2001
(73) Titulaire: Commissariat à l'énergie atomique et aux énergies alternatives, 75015 Paris (FR)
(72) Inventeur: GIDON, Pierre, F-38130 Echirolles (FR); PHILIPPE, Paul, F-38260 La Côte Saint André (FR)
(74) Mandataire: Weber, Etienne Nicolas
(86) Numéro de dépôt international: PCT/FR1999/002034
(87) Numéro de publication internationale: WO 2000/011714

(56) Documents cités:
- WO-A-95/19645
- GB-A- 1 136 840
- GB-A- 1 467 354
- US-A- 5 289 337
- "DIRECT ATTACHMENT OF A SILICON CARRIER FOR IC CHIPS TO A CIRCUIT CARD" IBM TECHNICAL DISCLOSURE BULLETIN, vol. 32, no. 4A, 1 septembre 1989 (1989-09-01), pages 93-95, XP000044995

## Description

### Domaine technique

L'invention concerne un procédé collectif de conditionnement d'une pluralité de composants formés initialement dans un même substrat. Le conditionnement peut notamment comporter l'individualisation de parties de substrat, appelées modules, comprenant chacun au moins un composant. Le conditionnement peut aussi comporter la prise de contacts électriques sur le ou les composants, la prise de contacts thermiques pour la dissipation de la chaleur produite par le ou les composants, de même que la mise sous boîtier des composants.

Par ailleurs, on entend par composant électronique aussi bien un composant individuel, en particulier un composant actif, par exemple un transistor, qu'un ensemble formé d'une pluralité de composants, tel qu'un étage d'amplification.

L'invention trouve des applications dans différents domaines de l'électronique et notamment dans le conditionnement de composants électroniques de puissance, qui requiert la mise en contact thermique des composants ou du substrat avec des radiateurs de dissipation.

### Etat de la technique antérieure

On connaît un certain nombre de techniques permettant de reporter un premier substrat, comprenant un certain nombre de composants, sur un deuxième substrat servant pour l'essentiel d'intermédiaire de connexion entre des plots de connexion et des bornes d'entrée/sortie des composants du premier substrat.

On connaît en particulier une technique dite d'hybridation par matériau fusible, ou "flip-chip". Selon cette technique des plages de connexion des substrats à hybrider, disposées en regard, sont reliées électriquement et mécaniquement au moyen de bossages, de matériau fusible qui sont collectivement soudés sur les plages de connexion.

La technique d'hybridation par matériau fusible peut être mise en oeuvre en particulier pour rapporter sur un substrat de support de grande taille une pluralité de puces électroniques comprenant chacune un ou plusieurs composants. Dans une telle application, il est cependant nécessaire de positionner individuellement l'ensemble des puces sur le substrat de support, avant d'entreprendre un traitement thermique permettant de faire fondre le matériau fusible des bossages pour une brasure collective.

Le positionnement individuel des puces constitue une étape coûteuse susceptible de nuire au rendement de la mise en oeuvre industrielle des assemblages.

La technique d'hybridation par matériau fusible peut également être mise en oeuvre pour l'interconnexion d'une pluralité de substrats empilés et connectés électriquement par des bossages formés sur leurs faces principales en regard.

Les prises de contact et les connexions vers l'extérieur de tels empilements sont formés sur les faces principales extérieures libres. Or, l'existence d'un grand nombre de bornes d'entrée/sortie sur les faces principales libres constitue un handicap pour l'installation de radiateurs de dissipation thermique, destinés aux composants de puissance.

A titre d'illustration de l'état de la technique décrit ci-dessus, on peut se reporter au document « Smart Power ICS Technologies and Applications » - B. Murani, F. Bertotti, G.A. Vignola - Spinger Chap. 13.

Une illustration complémentaire de l'état de la technique est donnée par les documents US-A-5 289 337, WO-A-9519645 et GB-A-1467354.

### Exposé de l'invention

L'invention a pour but de proposer un procédé permettant le conditionnement et en particulier la prise de contacts électriques pour des composants formés sur un substrat, ne présentant pas les limitations des techniques exposées ci-dessus.

Un but est en particulier de proposer un procédé permettant de traiter collectivement un grand nombre de composants formés initialement sur un même substrat, et qui soit par conséquent adapté à une mise en oeuvre industrielle.

Un but est aussi de proposer un procédé permettant de concilier les exigences d'une prise de contacts électriques sur un grand nombre de bornes d'entrée/sortie, et d'une prise de contact thermique efficace pour la dissipation de chaleur des composants de puissance.

Pour atteindre ces buts, l'invention a plus précisément pour objet un procédé collectif de conditionnement d'une pluralité de composants formés dans une première plaque de substrat, et séparés les uns des autres par des plages de séparation, chaque composant comprenant au moins un plot de contact affleurant à une première surface de ladite première plaque. Conformément à l'invention, le procédé comprend les étapes successives suivantes :
a) formation dans la première plaque, pour chaque composant, d'une dépression dans au moins une plage de séparation contiguë audit composant,
b) formation sur une deuxième plaque de substrat, de pistes conductrices associées respectivement aux plots de contact des composants de la première plaque, les pistes conductrices associées aux plots de contact d'un composant de la première plaque s'étendant respectivement sur une plage dite de connexion, la plage de connexion étant agencée de façon à coïncider avec la dépression contiguë audit composant de la première plaque de substrat, lorsque les première et deuxième plaques de substrat sont assemblées,
c) assemblage des première et deuxième plaques de substrat de façon à mettre en contact électrique les plots de contact des composants de la première plaque respectivement avec les pistes correspondantes de la deuxième plaque, et de façon à faire coïncider chaque plage de connexion de la deuxième plaque avec une dépression correspondante de la première plaque,
d) découpage de la première plaque par formation de tranchées dites proximales, autour des composants, les tranchées proximales débouchant dans lesdites dépressions des plages de séparation, et découpage de la deuxième plaque autour des composants par formation de tranchées, dites distales, plus éloignées des composants que les tranchées proximales dans des régions comprenant les plages de connexion, de façon à laisser dépasser au moins une partie des plages de connexion de la deuxième plaque, qui fait saillie sur au moins un chant latéral de la première plaque, les premier et deuxième découpages permettant d'individualiser des modules formés chacun d'une portion de la première plaque comprenant au moins un composant et une portion de la deuxième plaque.

Grâce au procédé de l'invention, l'opération d'interconnexion et d'assemblage des plaques est collective jusqu'au découpage des modules. Il est par conséquent adapté à une mise en oeuvre industrielle peu coûteuse.

De plus, comme la plage de connexion de la deuxième plaque de substrat dépasse latéralement par rapport à la première plaque, il est possible de réaliser des liaisons électriques sur cette plage sans encombrer les faces principales des plaques de substrat. Ces faces peuvent alors comporter éventuellement d'autres bornes de prise de contact, ou être équipées de radiateurs permettant de dissiper la chaleur produite par d'éventuels composants de puissance intégrés dans les plaques de substrat.

Le découpage des plaques de substrat, lors de l'étape d) est effectué par exemple par sciage. Il peut également être effectué au jet d'eau, et/ou par laser. Des techniques de gravure par ions réactifs peuvent également être mises en oeuvre, notamment en association avec les autres techniques de découpage. La gravure permet d'augmenter la précision et la qualité du fini du découpage.

En utilisant une scie à lames décalées ou à lames en marche d'escalier les découpages des première et deuxième plaques peuvent être concomitantes.

Lors de l'étape a) du procédé, la connexion électrique entre les plots de contact de la première plaque de substrat avec les pistes conductrices de la deuxième plaque de substrat peut avoir lieu au moyen de bossages de matériau fusible, selon la technique de "flip-chip" ou au moyen d'une colle conductrice, par exemple. La colle conductrice peut être anisotrope de façon à conduire le courant verticalement entre les plaques, mais sans conduire de courant latéralement entre différents plots de contact.

Dans ce deuxième cas, il est possible de façon avantageuse de pratiquer avant l'assemblage, dans la deuxième plaque de substrat des dépressions formant des réservoirs pour recueillir, lors de l'assemblage, un éventuel excès de colle.

Dans le cas où les connexions électriques sont réalisées par des bossages de matériau fusible, le procédé peut comporter, en outre, la mise en place d'un matériau de remplissage diélectrique entre les première et deuxième plaques de substrat, ledit matériau diélectrique entourant les bossages de matériau fusible.

Avantageusement, il est également possible, dans ce cas, de former une portion des pistes, destinée à recevoir les bossages de matériau fusible, dans une dépression de la deuxième plaque. La dépression est alors destinée à accueillir le matériau de remplissage diélectrique lors de l'assemblage.

De plus, on peut former la dépression de la deuxième plaque avec un rebord disposé en dehors de zones de dépression de la première plaque, de sorte qu'entre les rebords des dépressions des première et deuxième plaques se forme un étranglement. L'étranglement empêche le matériau de remplissage de s'étendre sur les plages de connexion lors de l'assemblage des plaques de substrat.

De façon additionnelle, il est possible de former dans la deuxième plaque de substrat au moins un composant, connecté à au moins l'une des pistes conductrices, associée à un plot de contact de la première plaque.

L'invention permet également d'obtenir un module électronique comprenant :
- une première plaque de substrat avec au moins un composant électronique et des plots de contact reliées au composant,
- une deuxième plaque de substrat, assemblée à la première plaque, la deuxième plaque comprenant des pistes conductrices reliées électriquement aux plots de contact, et s'étendant sur une plage de connexion de la deuxième plaque, qui fait saillie par rapport à la première plaque.

Un tel module peut être réalisé conformément au procédé décrit ci-dessus.

Lorsque les composants électroniques sont des composants de puissance, le module peut comporter en outre au moins un radiateur, fixé sur au moins une face libre des première et deuxième plaques.

L'invention permet aussi d'obtenir un dispositif électronique comprenant un boîtier, des broches de contact ménagées dans le boîtier et un module électronique tel que décrit ci-dessus, logé dans le boîtier. Les pistes conductrices de la plage de connexion sont reliées par fil respectivement aux broches de contact.

D'autres caractéristiques et avantages de la présente invention ressortiront mieux de la description qui va suivre, en référence aux figures des dessins annexés. Cette description est donnée à titre purement illustrait et non limitatif.

### Brève description des figures

- La figure 1 est une coupe schématique simplifiée d'une première plaque de substrat comprenant une pluralité de composants électroniques, illustrant une étape préparatoire du procédé de l'invention.
- La figure 2 est une coupe schématique simplifiée d'une deuxième plaque de substrat devant être assemblée à la première plaque.
- La figure 3 est une coupe schématique des première et deuxième plaques de substrat assemblées.
- Les figures 4 et 5 sont des coupes schématiques simplifiées d'un assemblage similaire à celui de la figure 3 et illustrant différentes possibilités de réalisation de connexions électriques entre les plaques de substrat.
- La figure 6 est une coupe schématique simplifiée d'un assemblage similaire à celui de la figure 3 et illustrant la réalisation de composants dans la deuxième plaque de substrat.
- La figure 7 est une coupe schématique de l'assemblage de la figure 3 et illustre une première étape de découpage.
- La figure 8 est une coupe schématique de l'assemblage de la figure 4 et illustre une deuxième étape de découpage pour individualiser des modules comprenant chacun au moins un composant.
- La figure 9 est une coupe schématique simplifiée d'un des modules et illustre son association à des radiateurs et à des broches de connexion.

### Description détaillée de modes de mise en oeuvre de l'invention

Dans la description qui suit, en référence aux dessins, des parties identiques, similaires ou équivalentes des figures sont repérées avec les mêmes références numériques.

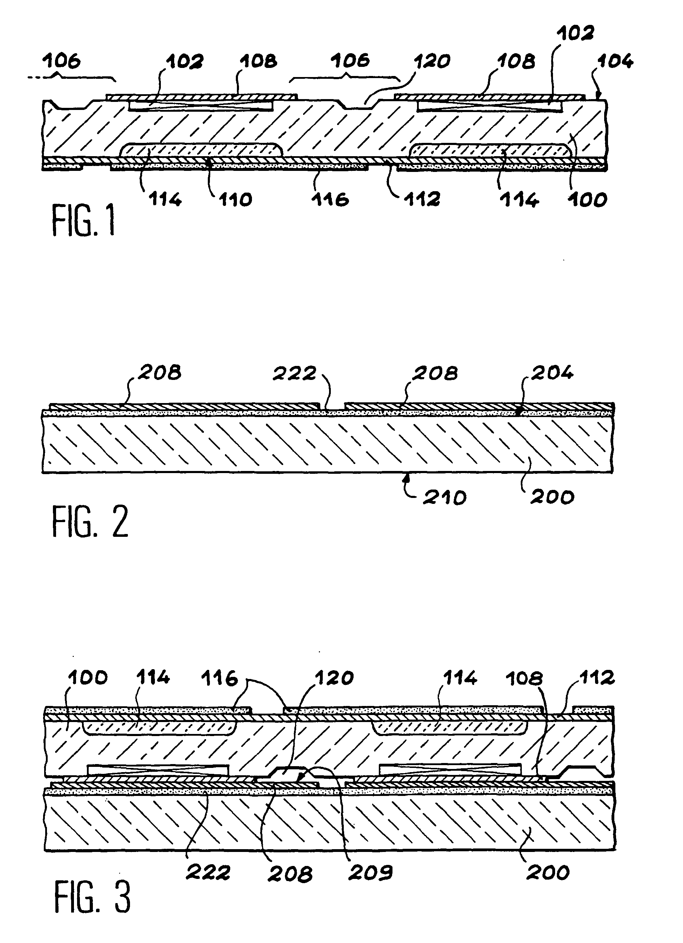

La référence 100 de la figure 1 indique une première plaque de substrat, par exemple une tranche de silicium dans laquelle sont formés une pluralité de composants 102. Sur la figure, seuls deux composants sont représentés pour des raisons de clarté. Les composants 102 peuvent être tous identiques les uns aux autres dans le cas d'une mise en oeuvre industrielle du procédé. Il sont formés, dans l'exemple de la figure, au niveau d'une face 104 du substrat, appelée "face avant".

Les composants sont séparés les uns des autres par des plages 106 appelées plages de séparation.

Des plots de contact métalliques 108 sont formés sur la face avant 104, au-dessus des composants et sont électriquement reliés à des bornes d'entrée/sortie ou des bornes d'alimentation des composants.

Pour des raisons de simplification, un seul plot de contact 108 est représenté sur la figure. Cependant, les composants peuvent être équipés d'une pluralité de tels plots, juxtaposés sur la face avant 104.

Une face 110 du substrat, appelée "face arrière", opposée à la face avant 104, est, équipée d'une couche de métal 112, telle qu'une couche ou un empilement de métaux comme l'aluminium, le cuivre, ou tungstène, cette couche formant également un ou plusieurs plots de connexion. Le substrat 100 peut comporter au voisinage de sa face arrière 110, des régions dopées 114, associées aux composants 102, en contact électrique avec la couche de métal 112.

La couche de métal 112 est par ailleurs localement isolée par une couche 116, dite de passivation, par exemple en silice ou en polymères.

On observe sur la figure 1 que des dépressions 120 sont pratiquées dans les plages de séparation 106. Ces dépressions, réalisées par exemple par gravure ou par sciage partiel du substrat, se présentent sous forme de rainures qui entourent tout ou partie de la périphérie des composants.

La profondeur des dépressions 120 est, par exemple, de l'ordre de 10µm pour une plaque de substrat 100 d'une épaisseur de l'ordre de 300 µm.

La figure 2 montre la préparation d'une deuxième plaque de substrat 200 avec une face avant 204 et une face arrière 210.

Le matériau de la deuxième plaque de substrat est de préférence choisi de façon à présenter une bonne conductivité thermique et une bonne résistance mécanique. De même, son épaisseur est choisie comme un compromis entre les exigences d'une bonne transmission de la chaleur (épaisseur faible) et d'une rigidité suffisante (épaisseur plus importante).

La deuxième plaque de substrat est, par exemple, une tranche de silicium d'une épaisseur de 300 µm.

La face avant 204 de la deuxième plaque de substrat 200 est recouverte d'une couche isolante électrique 222, par exemple en oxyde de silicium, sur laquelle sont formées des pistes conductrices 208. L'épaisseur de la couche isolante 222, généralement de l'ordre de quelques micromètres, peut être adaptée à une tenue en tension souhaitée entre les pistes conductrices 208 et le substrat 200. Lorsque la deuxième plaque de substrat est en un matériau isolant électrique, la couche isolante 222 peut être omise.

Les pistes conductrices 208, par exemple en aluminium et/ou en cuivre ou en alliage, s'étendent sur le deuxième substrat selon un motif correspondant au motif des plots de contact 108 de la première plaque de substrat de façon à coïncider, localement, avec ces plots lorsque les premier et deuxième substrats sont assemblés. Les pistes 208 peuvent être également connectées à des plots de contact formés sur la deuxième plaque de substrat et coïncident avec les plots de la première plaque.

La figure 3 montre une structure obtenue par assemblage des première et deuxième plaques 100, 200 respectivement par leur faces avant 104, 204.

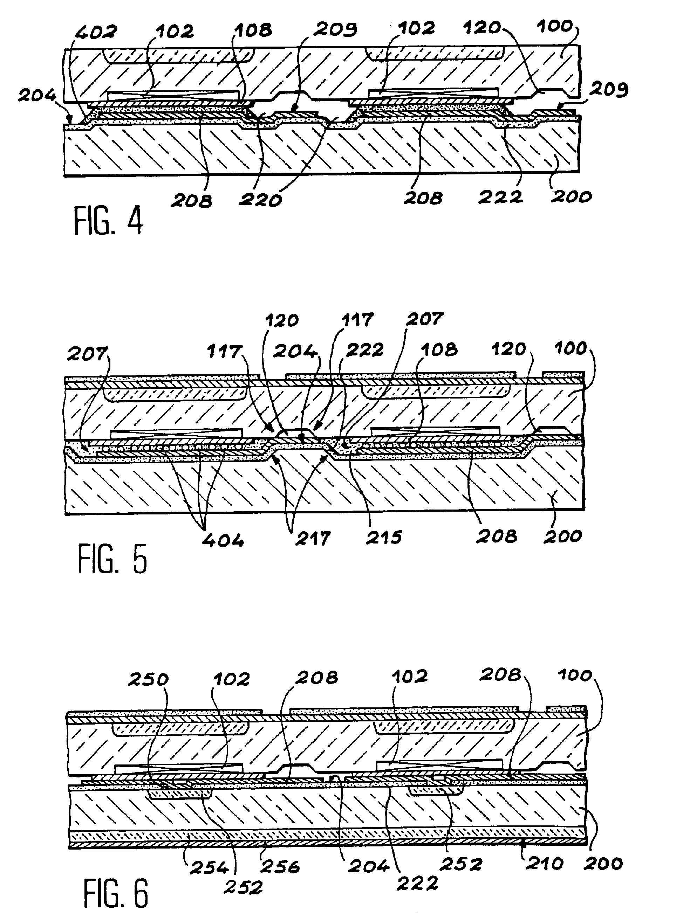

Les plots de contact 108, sont à présent en contact (électrique et mécanique) avec les pistes conductrices 208. Le contact peut être établi, par exemple, par soudage, par collage, par pression ou selon la technique de "flip-chip" déjà évoquée. Cet aspect sera décrit de façon plus détaillée en référence à la figure 5.

On observe, sur la figure 3, que les pistes conductrices 208 de la deuxième plaque de substrat sont dimensionnées et agencées de façon à s'étendre respectivement en face de la dépression 120 de la première plaque, contiguë au composant connecté à ces pistes. La partie d'extrémité des pistes qui s'étend en face de la dépression 120 est désignée par plage de connexion et repérée avec la référence 209 sur la figure.

La figure 4, décrite ci-après montre une possibilité particulière de connexion des plots de contact métallique 108 de la première plaque de substrat 100 avec les pistes conductrices 208 de la deuxième plaque de substrat 200. Dans l'exemple de la figure 4, le contact électrique est établi par l'intermédiaire d'une couche 402 de colle conductrice disposée respectivement entre chaque plot de contact 108 et la piste conductrice 208 qui y est associée.

La figure 4 monte en outre que des dépressions 220 peuvent être pratiquées dans la face avant 204 de la deuxième plaque de substrat en des emplacements faisant face de préférence aux extrémités des plots de contact 108 de la première plaque de substrat. Les dépressions 220 servent de réservoir pour accueillir un éventuel excès de colle conductrice, pour éviter que cette colle ne se répande sur la plage de connexion ou ne vienne court-circuiter plusieurs pistes.

Selon une variante illustrée par la figure 5, la connexion entre les plots de contact 108 de la première plaque de substrat 100 et les pistes conductrices 208 de la deuxième plaque de substrat 200 est effectuée par des billes 404 de matériau fusible selon la technique de "flip-chip", en soi connue.

La partie des pistes conductrices recevant les billes de matériau fusible 208 est formée dans des dépressions 207 pratiquées dans la face avant de la deuxième plaque de substrat 200. Les dépressions 207 sont de préférence comblées avec un matériau diélectrique 215 tel qu'un polymère qui se solidifie et qui s'étend entre les billes 404.

Un rebord 217 de chaque dépression 207 de la deuxième plaque de substrat 200 forme un étranglement en dehors des zones de dépression 120 correspondantes de la première plaque de substrat.

Cet étranglement permet d'empêcher le matériau diélectrique 215 de s'étendre sur la plage de connexion 209.

La figure 6, décrite ci-après, illustre une réalisation particulière du deuxième substrat 200 d'un assemblage de plaques de substrat conforme à la figure 3.

Des ouvertures 250 pratiquées dans la couche isolante 222, recouvrant la face avant 204 de la deuxième plaque de substrat 200, permettant la mise en contact électrique des pistes conductrices 208 avec des régions dopées 252 formées au voisinage de la face avant de la deuxième plaque de substrat

Une autre région dopée 254 est formée au voisinage de la face arrière de la deuxième plaque de substrat, en contact avec une couche de métal 256 formée sur ladite face arrière.

Les régions dopées 252, 254 de la deuxième plaque de substrat 200 permettent de former des composants, et en particulier des diodes.

Les diodes sont adressées par l'une des pistes conductrices 208, et par la couche de métal 256 sur la face arrière. Elles peuvent respectivement être connectées en parallèle avec les composants 102 formés dans la première plaque de substrat 100, afin de les protéger de surtensions, par exemple.

L'ensemble des opérations effectuées jusqu'à l'obtention d'une structure conforme aux figures 3, 4, 5 et 6, et notamment la liaison (hybridation) des plots de contact de la première plaque de substrat sur les pistes conductrices de la deuxième plaque, sont des opérations collectives pour l'ensemble des composants.

Les plaques de substrat sont ensuite découpées pour individualiser les composants. Selon le procédé décrit en référence aux figures, le découpage a lieu en deux étapes.

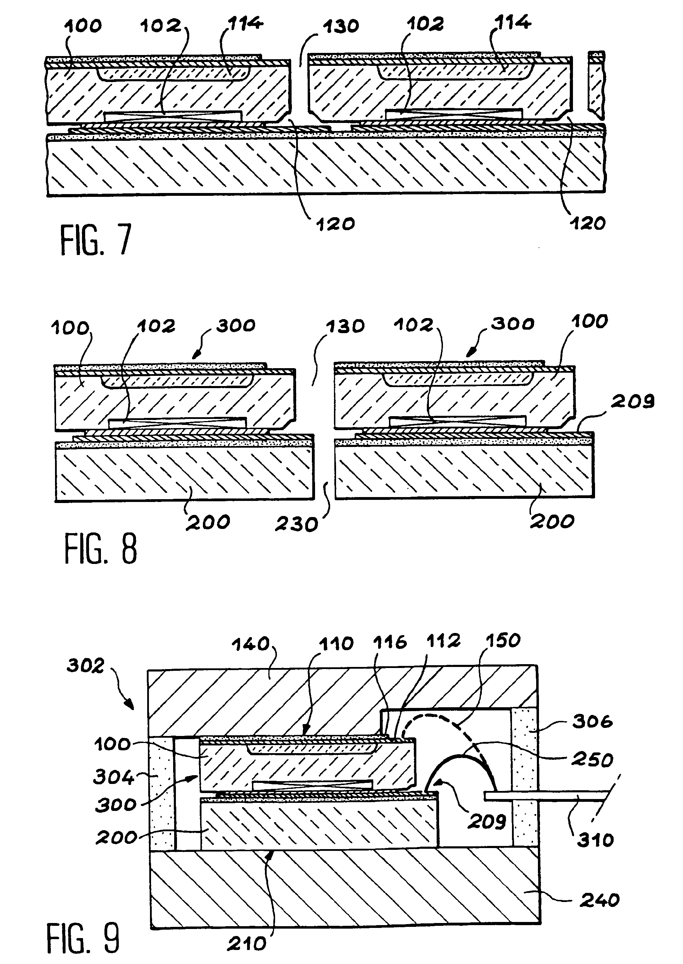

Une première étape de découpage est illustrée par la figure 7. Cette étape comporte un découpage de la première plaque de substrat 100 par sciage.

Le sciage permet de former dans la première plaque des tranchées 130 qui encadrent les composants 102 et qui débouchent notamment dans les dépressions 120 formées autour des composants. Le découpage peut être réalisé également selon d'autres techniques, telles que des techniques de gravure par exemple.

Une deuxième étape de découpage est illustrée à la figure 8.

Cette étape comporte le découpage de la deuxième plaque de substrat 200 et permet d'individualiser des modules 300. Chaque module 300 comprend une portion de la première plaque de substrat 100 et une portion de la deuxième plaque de substrat 200, et renferme au moins un composant.

On observe sur la figure 8 que des tranchées de découpage 230 formées dans la deuxième plaque de substrat 200 sont plus éloignées des composants dans les régions des plages de connexion 209, que les tranchées 130 formées par le découpage de la première plaque de substrat 100. Le découpage de la deuxième plaque de substrat permet ainsi de laisser dépasser au moins une partie de la plage de connexion 209 de chaque module. La plage de connexion fait ainsi saillie sur au moins un chant latéral du module, c'est-à-dire sur un flanc de tranchée de la première plaque de substrat.

Le découpage de la deuxième plaque de substrat peut s'étendre dans la première plaque de substrat pour élargir les tranchées de découpage de cette première plaque. Par ailleurs, les découpages des première et deuxième plaques de substrat peuvent être simultanés. Le décalage des tranchées, nécessaire pour laisser dépasser la plage de connexion 209, est alors obtenu, par exemple, par une scie à lame en marche d'escalier. Avantageusement, tout ou partie des modules issus des mêmes plaques de substrat peuvent être découpés simultanément avec une scie à lame multiples.

L'intérêt d'une plage de connexion 209 faisant saillie latéralement sur le chant des modules 300 est illustré par la figure 9 qui montre une possibilité de mise sous boîtier d'un module.

Le boîtier, repéré avec la référence générale 302, contient un module 300 et présente deux faces principales formées par des radiateurs 140, 240.

Un premier radiateur 140 forme une face "supérieure" du boîtier 302 et est mis en contact thermique avec la couche de passivation 116 qui recouvre la face arrière 110 de la première plaque de substrat 100 du module 300.

Un deuxième radiateur 240 forme une face "inférieure" du boîtier 302 et est mis en contact thermique avec la face arrière 210 de la deuxième plaque de substrat 200 du module 300.

Des parois latérales 304, 306, isolantes électriques, relient les radiateurs pour fermer le boîtier de façon sensiblement hermétique.

Des connexions 250 sont établies par fil métallique entre l'extrémité des pistes conductrices 208 s'étendant dans la plage de connexion 209 du deuxième substrat, et des broches de contact 310 traversant une paroi latérale 306 du boîtier 302.

Comme les connexions sont faites par les plages de connexion latérales 209, les faces arrière 110, 210 de la deuxième, mais aussi de la première plaque de substrat du module, ne comportent que peu, ou pas du tout, de prises de contact électrique. Cette caractéristique favorise le montage direct de chacune de ces faces sur un radiateur de la façon décrite ci-dessus. Une meilleure dissipation de la chaleur produite par les composants 102 est donc possible.

Eventuellement, la couche métallique 112 de prise de contact arrière de la première plaque de substrat 100 peut également être reliée à une broche de contact (non représentée) par un fil 150.

## Revendications

1. Procédé collectif de conditionnement d'une pluralité de composants (102) formés dans une première plaque de substrat (100) et séparés les uns des autres par des plages (106) de séparation, chaque composant comprenant au moins un plot de contact (108) affleurant à une première surface (104) de ladite plaque, le procédé comprenant les étapes successives suivantes :
a) formation dans la première plaque, pour chaque composant, d'une dépression (120) dans au moins une plage de séparation (106) contiguë audit composant,
b) formation sur une deuxième plaque de substrat (200) de pistes conductrices (208) associées respectivement aux plots de contact des composants de la première plaque, les pistes conductrices associées aux plots de contact d'un composant de la première plaque de substrat s'étendant respectivement sur une plage (209), dite de connexion, la plage de connexion étant agencée de façon à coïncider avec la dépression (120) contiguë audit composant (102) de la première plaque de substrat, lorsque les première et deuxième plaques de substrat sont assemblées,
c) assemblage des première et deuxième plaques de substrat (100, 200) de façon à mettre en contact électrique les plots de contact (108) des composants de la première plaque de substrat (106) respectivement avec les pistes (208) correspondantes de la deuxième plaque de substrat (208), et de façon à faire coïncider chaque plage de connexion de la deuxième plaque avec une dépression (120) correspondante de la première plaque de substrat,
d) découpage de la première plaque (100) par formation de tranchées (130), dites proximales, autour des composants (102), les tranchées proximales débouchant dans lesdites dépressions (120) des plages de séparation (106), et découpage de la deuxième plaque (200) par formation de tranchées (230), dites distales, plus éloignées des composants que les tranchées proximales dans des régions comprenant les plages de connexion, de façon à laisser dépasser au moins une partie des plages de connexion (209) de la deuxième plaque, qui fait saillie sur au moins un chant latéral de la première plaque, les première et deuxième découpages permettant d'individualiser des modules (300) formés chacun d'une portion de la première plaque comprenant au moins un composant et une portion de la deuxième plaque.

2. Procédé selon la revendication 1, dans lequel les découpages de l'étape d) sont effectués par sciage.

3. Procédé selon la revendication 2, dans lequel des découpages de la première et de la deuxième plaques de substrat (100, 200) ont lieu de façon concomitante en une seule passe de sciage avec une scie à lame en marche d'escalier.

4. Procédé selon la revendication 1, dans lequel on fixe en outre un radiateur (140, 240) sur au moins une face libre du module, opposée à la première surface (104) de la première plaque.

5. Procédé selon la revendication 1 comprenant en outre une étape de connexion par fils métalliques (250) des pistes (208) s'étendant dans la plage de connexion (209) de chaque module (300), à des broches de contact (310) d'un boîtier de réception (302) du module.

6. Procédé selon la revendication 1, dans lequel l'assemblage des plaques de substrat comporte la connexion des plots de contact (108) de la première plaque (100) avec les pistes conductrices (208) de la deuxième plaque (200) au moyen de bossages (404) de matériau fusible.

7. Procédé selon la revendication 6, comprenant en outre la mise en place d'un matériau de remplissage diélectrique (215) entre les première et deuxième plaques de substrat (100, 200), ledit matériau diélectrique entourant les bossages (404) de matériau fusible.

8. Procédé selon la revendication 7, dans lequel on forme une portion des pistes (208), destinée à recevoir les bossages dans au moins une dépression (207) de la deuxième plaque (200), la dépression étant destinée à accueillir le matériau de remplissage lors de l'assemblage.

9. Procédé selon la revendication 8, dans lequel on forme la dépression de la deuxième plaque de substrat avec un rebord (217) disposé en dehors de zones de dépression (120) de la première plaque de substrat, de sorte que des zones entre les rebords des dépressions des première et deuxième plaques forment un étranglement.

10. Procédé selon la revendication 1, dans lequel l'assemblage comporte le collage des plots de contact (108) de la première plaque de substrat (100) sur les pistes conductrices (208) de la deuxième plaque de substrat (200) au moyen d'une colle conductrice (402).

11. Procédé selon la revendication 10, dans lequel, avant l'assemblage, on pratique dans la deuxième plaque de substrat (200) des dépressions (220) formant des réservoirs pour recueillir un éventuel excès de colle, lors de l'assemblage.

12. Procédé selon la revendication 1, dans lequel on forme dans la deuxième plaque de substrat (200) au moins un composant (252, 254), connecté à au moins l'une des pistes conductrices (208) associée à un plot de contact (108) de la première plaque de substrat (100).

13. Procédé selon la revendication 12, dans lequel le composant est une diode.

## Claims

1. Process for collectively packaging a plurality of components (102) formed in a first substrate board (100) and separated from each other by separation strips (106), each component comprising at least one contact pad (108) flush with a first surface (104) of the said first board, the process comprising the following steps in sequence:
a) formation of a depression (120) in at least one separation strip (106) contiguous to the said component, in the first board, for each component,
b) formation of conducting tracks (208) on a second substrate board (200), the tracks being respectively associated with the contact pads of the components on the first board, the conducting tracks associated with the contact pads of a component on the first board respectively extending onto a "connection" strip (209), the connection strip being arranged to coincide with the depression (120) contiguous with the said component (102) on the first substrate board, when the first and second substrate boards are assembled,
c) assembly of the first and second substrate boards (100, 200) so as to bring the contact pads (108) of the components of the first substrate board (106) into electrical contact with the corresponding tracks on the second substrate board (208) respectively, and to make each connection strip on the second board coincide with a corresponding depression (120) on the first substrate board,
d) cutting out the first board (100) by the formation of "proximal" trenches (130) around the components (102), the proximal trenches opening up into the said depressions (120) in the separation strips (106), and cutting out the second board (200) by the formation of "distal" trenches (230), further away from the components than the proximal trenches in regions comprising connection strips, in order to allow the connection strips (209) on the second board to project at least partially beyond at least one edge of the first board, the first and second cut outs being used to individualise the modules (230) each formed of a portion of the first board comprising at least one component and one portion of the second board.

2. Process according to claim 1, in which the cuts in step d) are done by sawing.

3. Process according to claim 2, in which the cuts in the first and the second substrate boards (100, 200) are made together in a single saw pass with a step-shaped saw blade.

4. Process according to claim 1 in which a heat sink (140, 240) is also fixed on at least one free face of the module opposite the first face (104) of the first board.

5. Process according to claim 1, also comprising a step in which the tracks (208) extending into the connection strip (209) on each module (300) are connected by metallic wires (250) to contact pins (310) of a package (302) containing the module.

6. Process according to claim 1, in which the substrate boards assembly includes the connection of the contact pads (108) of the first board (100) with the conducting tracks (208) of the second board (200) by means of bosses (404) of meltable material.

7. Process according to claim 6, also comprising placement of a dielectric filling material (215) between the first and second substrate boards (100, 200), the said dielectric material surrounding the bosses (404) of meltable material.

8. Process according to claim 7, in which a portion of the tracks (208) is formed, designed to contain the bosses in at least one depression (207) in the second board (200), the depression being intended to contain the filling material during assembly.

9. Process according to claim 8, in which the depression in the second substrate board is provided with an upstand (217) located outside the depression areas (120) of the first substrate board, such that the areas between the upstands around the depressions of the first and second boards form a bottleneck.

10. Process according to claim 1, in which the assembly includes gluing of the contact pads (108) of the first substrate board (100) onto the conducting tracks (208) of the second substrate board (200) using a conducting glue (402).

11. Process according to claim 10, in which reservoir-forming depressions (220) are formed in the second substrate board (200) before assembly, to contain any excess glue during assembly.

12. Process according to claim 1, in which at least one component (252, 254) is formed in the second substrate board (200), connected to at least one of the conducting tracks (208) associated with a contact pad (108) on the first substrate board (100).

13. Process according to claim 12, in which the component is a diode.

## Patentansprüche

1. Sammelkonditionierungsverfahren einer Vielzahl von Bauelementen (102), ausgebildet in einer ersten Substratplatte (100) und voneinander getrennt durch Trennbereiche (106), wobei jedes Bauelement wenigstens ein mit einer ersten Oberfläche (104) der genannten Platte bündiges Kontaktflächenelement (108) umfasst, und das Verfahren die folgenden sukzessiven Schritte umfasst:
a) Bildung - in der ersten Platte - einer Vertiefung (120) in wenigstens einem an das genannte Bauelement angrenzenden Trennbereich (106),
b) Bildung - auf einer zweiten Substratplatte (200) - von Leiterbahnen (208), jeweils verbunden mit den Kontaktflächenelementen der Bauelemente der ersten Substratplatte, wobei die mit den Kontaktflächenelementen der ersten Substratplatte verbundenen Leiterbahnen sich jeweils über einen sogenannten Verbindungsbereich (209) erstrecken und dieser Verbindungsbereich dabei so vorgesehen ist, dass er mit an das genannte Bauelement angrenzenden Vertiefung (120) der ersten Substratplatte übereinstimmt, wenn die erste und die zweite Substratplatte zusammengebaut werden,
c) Zusammenbau der ersten und der zweiten Substratplatte (100, 200), um den elektrischen Kontakt zwischen den Kontaktflächenelementen (108) der Bauelemente der ersten Substratplatte (106) jeweils mit entsprechenden Leiterbahnen (208) der zweiten Substratplatte (200) herzustellen, und um jeden Verbindungsbereich der zweiten Substratplatte in Übereinstimmung zu bringen mit einer entsprechenden Vertiefung (120) der ersten Substratplatte,
d) Zerlegung der ersten Platte (100) durch Bildung von sogenannten proximalen Gräben (130) um die Bauelemente (102) herum, wobei die proximalen Gräben in den genannten Vertiefungen (120) der Trennbereiche (106) münden, und Zerlegung der zweiten Platte (200) durch Bildung von sogenannten distalen Gräben (230), weiter entfernt von den Bauelementen als die proximalen Gräben in den Verbindungsbereiche umfassenden Regionen, um wenigstens einen Teil der Verbindungsbereiche (209) vorstehen zu lassen, der über wenigstens eine seitliche Kante der ersten Platte hinausragt, wobei die erste und die zweite Zerlegung ermöglichen, Module (300) zu vereinzeln, jeder gebildet durch ein wenigstens ein ein Bauelement umfassendes Teilstück der ersten Platte und ein Teilstück der zweiten Platte.

2. Verfahren nach Anspruch 1, bei dem die Zerlegungen des Schritts d) durch Sägen erfolgen.

3. Verfahren nach Anspruch 2, bei dem die Zerlegungen der ersten und der zweiten Substratplatte (100, 200) auf konkomitante Weise in einem Sägedurchgang mit einer Stufenblattsäge (scie à lame en marche d'escalier) erfolgt.

4. Verfahren nach Anspruch 1, bei dem man außerdem auf wenigstens einer der ersten Oberfläche (104) der ersten Platte entgegengesetzten freien Seite des Moduls einen Radiator (140, 240) befestigt.

5. Verfahren nach Anspruch 1 mit außerdem einem Schritt, in dem durch Metalldrähte (250), die sich in dem Verbindungsbereich (209) jedes Moduls (300) erstrecken, Leiterbahnen (208) mit Kontaktstiften (310) eines Aufnahmegehäuses (302) des Moduls verbunden werden.

6. Verfahren nach Anspruch 1, bei dem der Zusammenbau der Substratplatten das Verbinden der Kontaktstifte (108) der ersten Platte (100) mit den Leiterbahnen (208) der zweiten Platte (200) durch Buckel (404) aus schmelzbarem Material umfasst.

7. Verfahren nach Anspruch 6 mit außerdem dem Einbringen eines dielektrischen Füllmaterials (215) zwischen der ersten und zweiten Substratplatte (100, 200), wobei das genannte dielektrische Material die Buckel (404) aus schmelzbarem Material umgibt.

8. Verfahren nach Anspruch 7, bei dem man ein zur Aufnahme der Buckel in wenigstens einer Vertiefung (207) der zweiten Platte (200) bestimmtes Teilstück der Leiterbahnen (208) bildet, wobei die Vertiefung dazu bestimmt ist, beim Zusammenbauen das Füllmaterial aufzunehmen.

9. Verfahren nach Anspruch 8, bei dem man die Vertiefung der zweiten Substratplatte mit einem Rand (217) ausbildet, der sich außerhalb von Vertiefungszonen (120) der ersten Substratplatte befindet, so dass die Bereiche zwischen den Rändern der Vertiefungen der ersten und zweiten Platte einen Engpass bilden.

10. Verfahren nach Anspruch 1, bei dem der Zusammenbau das Festkleben der Kontaktstifte (108) der ersten Substratplatte (100) auf den Leiterbahnen (208) der zweiten Substratplatte (200) mittels eines leitfähigen Klebstoffs (402) umfasst.

11. Verfahren nach Anspruch 10, bei dem man vor dem Zusammenbauen in der zweiten Substratplatte (200) Vertiefungen (220) herstellt, die beim Zusammenbauen Speicher für die Aufnahme eines eventuellen Klebstoffüberschusses bilden.

12. Verfahren nach Anspruch 1, bei dem man in der zweiten Substratplatte (200) wenigstens ein Bauelement (252, 254) ausbildet, das mit wenigstens einer der einem Kontaktstift (108) der ersten Substratplatte (100) zugeordneten Leiterbahnen (208) verbunden ist.

13. Verfahren nach Anspruch 12, bei dem das Bauelement eine Diode ist.
